# EUROPEAN PATENT APPLICATION

(11) **EP 0 849 040 A2**
(43) Date of publication of application: **24.06.1998**
(21) Application number: 97310334.4
(22) Date of filing: 19.12.1997
(51) Int. Cl.: B24B 37/04, H01L 21/304, B24B 55/03, B01D 39/16

(54) **Method of polishing**

(30) Priority: 19.12.1996 US 33681 P
(71) Applicant: TEXAS INSTRUMENTS INCORPORATED, Dallas Texas 75265 (US)
(72) Inventor: Bawa, Mohendra S., Plano, Texas (US); Simpson, Vikki Sue, Sherman, Texas (US); Grimes, Michael H., Plano, Texas (US); Allen, Franklin Louis, Sherman, Texas (US); L'Anglois, Kenneth John, Sherman, Texas (US); Miller, Palmer Arthur, Sherman, Texas (US); Etheridge, Gary Lee, Sherman, Texas (US)
(74) Representative: Darby, David Thomas

(57) **Abstract**

A method for managing particulate in a chemical-mechanical polishing slurry (28), the method comprising circulating the polishing slurry (28) in a chemical-mechanical wafer polishing apparatus (10), passing the polishing slurry through a filtration system (39) and filtering the particulate, including aggregates, precipitates and particles of SiOₓ created during the polishing process, out of the polishing slurry. The filtration system (39) may comprise a polypropylene filter or a hydrophilic polypropylene filter and the filter may have an internal surface area of approximately 72 square inches which is wetted before passing the polishing slurry therethrough. The filter has a pore size between about 25 and 100 microns and preferably about 50 microns.

## Description

### TECHNICAL FIELD OF THE INVENTION

This invention relates, in general, to integrated circuits and, more particularly, to the management of particulate in a chemical-mechanical silicon polishing slurry. In particular, the invention relates to a method for removing aggregates, precipitates and particles of silicon and silicon oxide created during a chemical-mechanical polishing process from a siliceous chemical-mechanical silicon polishing slurry.

### BACKGROUND OF THE INVENTION

Without limiting the scope of the invention, its background is described in connection with the processing of silicon wafer production slurries, as an example.

Heretofore, in this field, chemical-mechanical polishing of silicon wafers has been performed at various stages of the fabrication of integrated circuits having planarized irregular top surface topography. For example, in the process for fabricating modern semiconductor integrated circuits, it is necessary to form conductive lines of other structures above previously formed structures. Prior structure formation, however, often leaves the top surface topography of the silicon wafer highly irregular. As a result of these irregularities, deposition of subsequent layers of material could easily result in incomplete coverage, breaks in the deposited material, or voids if it were deposited directly over the aforementioned highly irregular surfaces. If the irregularities are not alleviated at each major processing step, the top surface topography of the surface irregularities will tend to become even more irregular, causing further problems as the layers stack up in the further processing of the semiconductor structure.

Depending upon the type of material used and their intended purposes, numerous undesirable characteristics are produced when these deposition irregularities occur. Incomplete coverage of an insulating oxide layer can lead to short circuits between metalization layers. Likewise, voids can trap air or processing gases, either contaminating further processing steps, or simply lowering overall device reliability. Sharp points on conductors can result in unusual, undesirable field effects. One problem that is widely recognized in the wafer manufacturing process is that, in general, processing high density circuits over highly irregular structures can lead to very poor yields and device performance.

Consequently, it is desirable to effect some type of planarization or flattening of the surface of integrated circuit structures in order to facilitate the processing of multi-layer integrated circuits and to improve their yield, performance, and reliability. In fact, all of today's high-density integrated circuit fabrication techniques make use of some method of forming planarized structures at critical points in the fabrication process.

Conventionally, the polishing apparatus used to planarize a semiconductor wafer has been a turntable, often referred to as a rotating platen, and a ring that exerts a constant pressure on the turntable. A polishing pad is typically attached to the upper surface of the turntable. The semiconductor wafer to be polished, is placed on the polishing pad and clamped between the top ring and the turntable. The semiconductor wafer is securably fixed to the lower surface of the top ring by wax, a pad or via suction so that the semiconductor wafer can be rotated integrally with the top ring during polishing.

While the turntable is rotated, a metered stream of slurry from a slurry supply is delivered to the upper surface of the polishing pad. Typically, the slurry is a liquid comprising chemicals and an abrasive. For example, slurry chemistry generally consists of a basic solution having a pH of about 11. This alkaline polishing slurry may also contain fine polishing particles such as colloidal silica (SiO₂).

As wafer manufacturing technology advances, the semiconductor industry relies more and more on integrated circuits having smaller and smaller wiring patterns. These smaller wiring patterns are interconnected within narrower spaces, requiring improved methods for planarizing the irregular surface topography of silicon wafers. Several parameters have been discovered that affect the quality of chemical-mechanical polishing of silicon wafers. Specifically, mechanical factors such as pressure exerted by the top ring on the turntable and the platen speed affect yield. The chemical factors that affect yield include the type of slurry used, slurry pH, slurry additives, slurry temperature, slurry dilution ratio, slurry batch volume and slurry volumetric flow rate. Each of the mechanical and chemical factors contribute to the quality of the planarized surface on the silicon wafer, which concomitantly affects the yield, at each step, of the semiconductor integrated circuit process.

More specifically, it has been discovered that the quality of the finish during the planarization process is directly related to the amount of silica aggregates and precipitates in the slurry. Therefore, what is needed is a method for removing silicon oxide particles from the polishing slurry used to process silicon wafers during the chemical-mechanical polishing. Improved methods of chemical-mechanical polishing will increase the slurry life, resulting in greater recirculation of the silicon polishing slurry. The longer slurry life results in both cost savings from the decreased use of slurry batches, as well as a reduced environmental impact from the discarded volumes of polishing slurry.

### SUMMARY OF THE INVENTION

The present invention provides an improved aggregate and precipitate removal system comprising a filtration unit for removing particulate matter from a polishing slurry created during chemical-mechanical wafer polishing. The filter disclosed causes a dramatic increase in the longevity of polishing slurry solutions used to polish semiconductor silicon wafers. The present invention also includes a method of using the filter thereby allowing for recycling and reusing the polishing slurry after each production cycle. The aggregate and precipitate removal system increases polishing slurry life, thereby minimizing the need to discard polishing slurry.

One aspect of the present invention is a filtration unit that is disposed within the slurry recirculation system that serves to filter SiOₓ aggregates and precipitates. By filtering the silicon oxide aggregates and precipitates the method improves upon current technology by increasing the stability and longevity of a polishing slurry. The filtering unit may be, for example, a polypropylene filter having a pore size between about 25 and 100 micrometers and preferably a pore size of about 50 micrometers.

In one aspect of the present invention, the filter or filtration unit, is located at an easily accessible point in the slurry recirculation system. For example, the filter or filtration unit may be located near the defoaming unit. The slurry filter or filtration unit may be attached to the slurry recirculation system by a number of different methods. One method, for example, is the use of O-rings located at the end of the filtration unit, that slide and grip the slurry diverter drain. Another means of attaching the filter or filtration unit is by alligator clips that help fasten the filter to the diverter drain. Yet another means of attaching the filter or filtration unit is via two cells with a quick disconnect that allow the operator to rapidly, and cleanly, remove and replace the filter or filter unit from the slurry diverter drain.

In general, the method comprises placing a polypropylene, polyethylene, polyvinyl chloride, polyvinylidene chloride, polyvinylidene fluoride, polyester or glass fabric filter of a predetermined pore size having an internal wetted surface during the recirculation of a polishing slurry in a chemical-mechanical wafer polishing apparatus. The removal of aggregate and precipitated particulate matter in the slurry recirculating system is caused by an ergonomically designed filter that is easy to introduce and replace in present recirculating systems.

### DESCRIPTION OF THE DRAWINGS

The present invention will now be further described by way of example, with reference to the accompanying drawings in which:
Figure 1 is a simplified illustration of a wafer polishing apparatus having a filter; and
Figure 2 is a plan view of a slurry filter of the present invention;
Figure 3 is a plan view of an unfolded slurry filter of the present invention;
Figure 4 is a simplified illustration of a wafer polishing apparatus having a filtration unit; and
Figure 5 is a more detailed view of a filtration unit of the present invention.

Corresponding numerals and symbols in different figures refer to corresponding parts unless otherwise specified.

### DETAILED DESCRIPTION OF THE INVENTION

While the making and using of various embodiments are discussed in detail below, it should be appreciated that these teachings provide many applicable inventive concepts that can be embodied in a wide variety of specific contexts. The specific embodiments discussed herein are merely illustrative of specific ways to make and use the apparatus and method and not be interpreted as limiting the spirit and scope of the teachings disclosed herein.

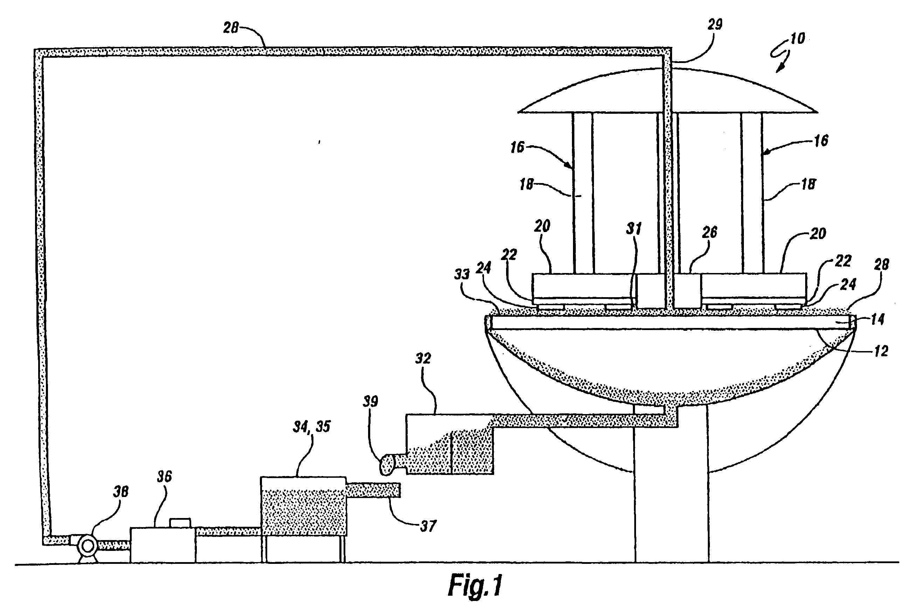

In Figure 1, an apparatus for chemical-mechanical polishing of various workpieces, such as semiconductor wafers, is generally depicted as 10. The polishing apparatus 10 includes a lower platen 12 having a polishing pad 14 attached thereto on the upper surface of the lower platen 12. The polishing apparatus 10 may include a plurality of polishing units 16. Each polishing unit 16 includes a shaft 18, an upper platen 20, and a carrier plate 22. Each polishing unit 16 holds at least one semiconductor wafer 24.

In operation, the lower platen 12 and the polishing unit 16 are counter rotated such that the lower surface of the semiconductor wafers 24 contacts the upper surface of the polishing pad 14. The polishing units 16 are preferably rotated by friction generated between the polished surface of semiconductor wafer 24 and polishing pad 14. The lower platen 12 and the upper platens 20 both rotate counterclockwise while the center drive 26 rotates clockwise while evenly distributing slurry 28 across polishing pad 14 through a circular gap between center drive 26 and polishing pad 14. The slurry 28 provides for both chemical and mechanical polishing of the silicon wafers 24.

During polishing, the temperature of slurry 28 increases and slurry 28 entrains silicon and silicon oxide particles released by the chemical-mechanical polishing process from the semiconductor silicon wafer 24. Slurry 28 is then recirculated and reused. The slurry recirculation process may include a defoaming chamber 32, a pH control chamber 34, a reduction-oxidation potential control chamber 35 and a temperature control chamber 36. The slurry recirculation pathway may also include slurry diverter 37 and pump 38, that recirculates the slurry 28 to the polishing units 16. A filter 39 may be located just before the slurry diverter 37, by attaching filter 39 to the drain of defoaming chamber 32. Even though filter 39 is depicted downstream of defoaming chamber 32, it should be noted by one skilled in the art that filter 39 may be located in a variety of locations, including between pH control chamber 34 and temperature control chamber 36 or immediately upstream or downstream of pump 38.

The slurry 28 may contain particles of silica of the order of 20 to 100 nanometers in diameter. The slurry 28 also comprises water, and silicon oxide particles stabilized by sodium cations. The hydration of the surface of the silica particles by water molecules and the surrounding cloud of sodium cations stabilize the slurry 28 against coagulation, settling-out, gelling, and precipitation. The range of silica to alkali ratio, however, increases with the use of the slurry 28 in the polishing apparatus 10. The increase in the silica to alkali ratio destabilizes the slurry 28 and results in the aggregation and precipitation of the silica colloidal particles from the slurry 28, which further changes the silica to alkali ratio. The aggregates and precipitates interfere with the polishing process and produce polish defects.

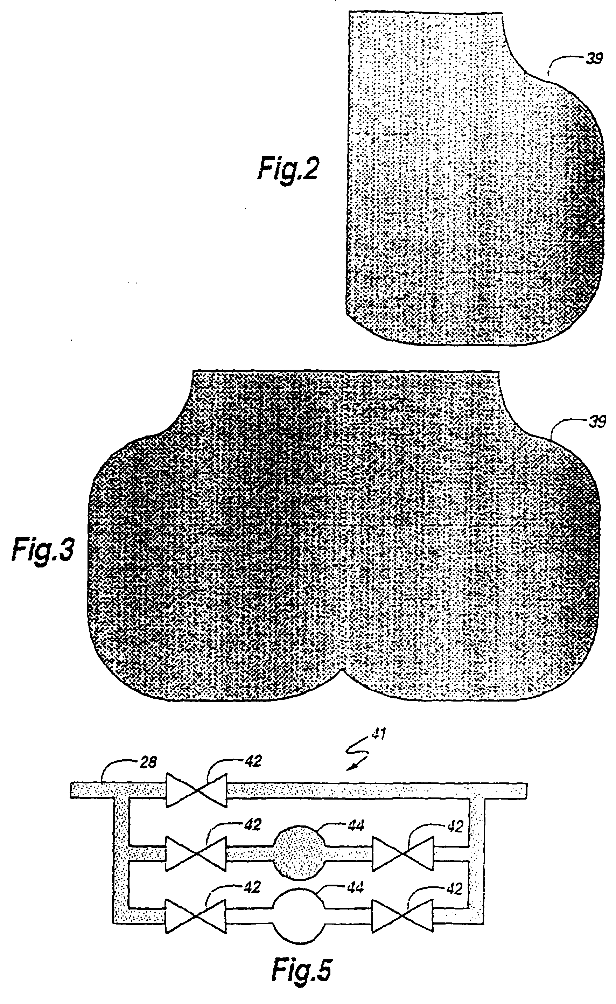

In Figures 2 and 3, slurry 39 filter is depicted. The filter 39 may comprise a polypropylene filter 39 having a pore size between about 25 and 100 micrometers and preferably about 50 micrometers. Alternatively, a hydrophilic polypropylene filter 39 with the same pore size may be used to remove aggregates and precipitates from the polishing slurry 28.

The necessity for, and the pore size of filter 39 were attained through both theoretical and empirical studies. Likewise, the shape and the wetable surface area of the filtering unit were determined. The filter 39 is provided with a wetable surface area of 72 square inch, which has been found to remove sufficient silica aggregates and precipitates to increase the useable life of polishing slurry from six runs to at least 30 runs. The pore size of the filter 39 is useful for both small silica aggregates and large aggregates of even 400 to 600 nanometers in diameter.

Furthermore, the filter 39 must be able to handle varying flow rates during chemical-mechanical polishing, as increasing and decreasing the rate of slurry flow is used to affect the temperature of the slurry 28. The filter 39 is able to function at flow rates of, for example, three to three and a half liters per minute. It has been found that wetting the filter 39 prior to placing in the slurry recirculation system helps to decrease the flow resistance through filter 39. The filter 39 may be wetted, by for example, isopropanol. Other like alcohols may be used to wet the filter 39.

The filter 39 may be placed in one or more strategic locations throughout the circulation path of the slurry 28. For example, the filter 39 may be placed on the drain that feeds the slurry diverter 37. A filter 39 may also be placed following a pH control chamber 34, or a temperature control chamber 36. After the slurry 28 passes through a filter 39, a pump 38 circulates the slurry 28 back to the surface of the polishing pad 14.

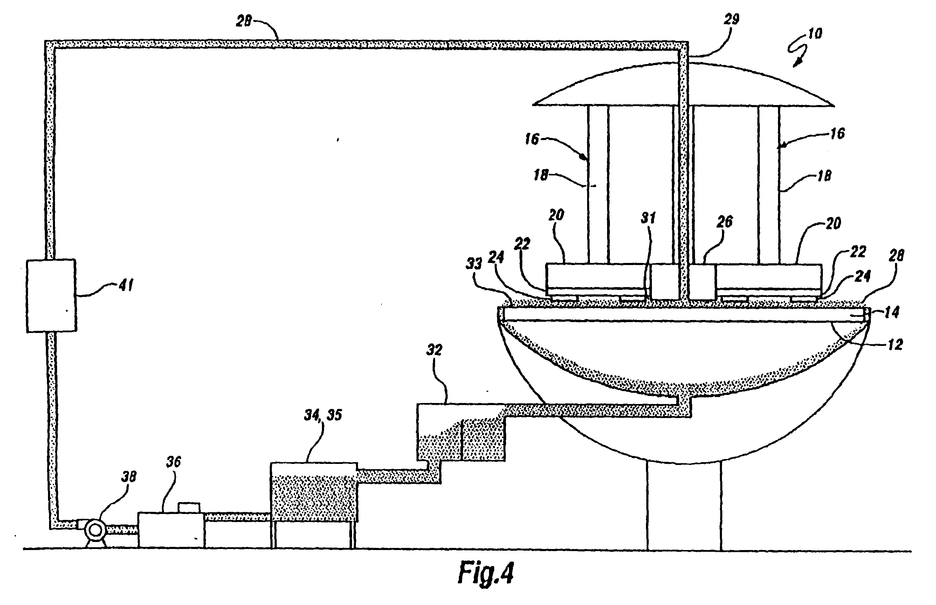

Figure 4 depicts another embodiment of an apparatus in which an in-line filtration unit 41 is placed downstream of pump 38. In this embodiment, the slurry 28 may travel through defoaming chamber 32, pH control chamber 34, reduction-oxidation potential control chamber 35 and temperature control chamber 36. Even though filtration unit 41 is depicted downstream of pump 38, it should be noted by one skilled in the art that filtration unit 41 may be located in a variety of locations, including between defoaming chamber 32 and pH control chamber 34, between pH control chamber 34 and temperature control chamber 36 or immediately upstream of pump 38.

In Figure 5, an example of one configuration of an in-line filter unit 41 is depicted. In-line filtration unit 41 includes a plurality of solenoids 42 for controlling the direction of flow of slurry 28. In-line filtration unit 41 may be configured such that slurry 28 passes through filtration unit 41 without passing through a filter 44. Alternatively, slurry 28 may pass through one or both filters 44. In this particular example, a filter 44 may be replaced during a polishing run by isolating that filter from slurry 28. Filter 44 may be constructed from polypropylene or a hydrophilic polypropylene or other material such as polyethylene, polyvinyl chloride, polyvinylidene chloride, polyvinylidene fluoride, polyester or glass fabric. Filter 44 preferably has a pore size between about 25 and 100 micrometers and, more preferably, about 50 micrometers.

The apparatus may be used with any of the chemical-mechanical polishing units available for silicon semiconductor wafer polishing. In one embodiment, the apparatus may be used with an Applied Materials polishing unit. However, all like-production units can be used with the filter 39 or filtration unit 41.

An agent may also be added for adjusting the pH or the redox potential of slurry 28. A pH control agent may be selected from the chemical family known as alkalis such as sodium hydroxide (NaOH) or potassium hydroxide (KOH). The addition of one of these alkalis allows the pH of the slurry 28 to be maintaining between about 9.7 and 11.7. The addition of the alkalis also helps to dissolve any silicon oxide aggregates in the slurry 28 and minimizes or eliminates precipitation of silicon oxide in the slurry 28.

The alkalis may be introduced into the slurry 28 in a pH control chamber 34. The necessity for and the amount of agent introduced into the slurry 28 in a pH control chamber 34 may be determined from slurry samples taken at strategic locations throughout the circulation path of the slurry 28. For example, pH may be tested proximate to the center drive 26, in the defoaming chamber 32, or in the pH control chamber 34. The alkalis may be introduced in the pH control chamber 36 from an agent reservoir (not pictured). After the slurry 28 passes through the pH control chamber 36, a pump 38 circulates the slurry 28 back to the surface of the polishing pad 14.

As the polishing process progresses, the slurry 28 becomes neutralized due to, among other things, the silicon introduced into the slurry 28 as a result of the polishing process. As the slurry 28 is neutralized, the buffer capacity of the slurry 28 is reduced and the quality of the finish on the silicon wafer is diminished.

In order to control the pH of the slurry 28, the rate of neutralization of the slurry 28 and the resulting pH of the slurry 28 must be determined. The pH of the slurry is monitored by sampling the slurry 28 in one or more locations along the slurry circulation path and testing for the pH of the slurry 28 is performed in a conventional manner. For example, a conventional electronic pH meter may be used to continuously monitor the slurry pH.

The temperature of the polishing slurry 28 may be varied by a temperature control chamber 36, as depicted in Figures 1 and 4. The necessity for, and the amount of, cooling and heating of the slurry 28 in the temperature chamber 34 may be determined from slurry temperature samples taken at one or more strategic locations throughout the circulation path of the slurry 28. For example, the temperature may be tested proximate to the center drive 26, in the defoaming chamber 32, or directly upstream of the temperature control chamber 34. After the slurry 28 passes through the temperature control chamber 34, a pump 38 circulates the slurry 28 back to the surface of the polishing pad 14.

An alternative embodiment encompasses the use of a temperature controller chamber 34 that receives the input from one or more temperature probes located to sample slurry temperature. Slurry temperature may be sampled in intervals, or may be monitored continuously. The output from the probes may be directed to a centralized temperature controlled chamber 36, that may also be used by the operator to preset the slurry temperature during a polishing run. In operation, a user-defined temperature is set before the polishing run to, for example, pre-heat the slurry. The temperature set by the operator may also vary throughout the polishing run to between about 17 and 70 degrees Celsius and preferably to about 25 degrees Celsius, depending on the specific needs of the wafer.

The temperature control chamber 36 may include, for example, a slurry chiller located in parallel with a slurry heater. Alternatively the chiller and the heater may be combined in series. One example of a chiller mechanism is a serpentine chiller that is located within the chiller and comes in contact with the slurry. Another example of the temperature control chamber 34 is where the heating mechanism is a serpentine heater that is disposed along-side or within the serpentine chiller, wherein slurry 28 comes in contact with the elements almost concurrently. In another example, the slurry chiller and slurry heater may be shell and tube heat exchangers.

Either upstream or downstream from the heater and the chiller, are one or more temperature controlled solenoids, that serve to open slurry 28 flow into either the chiller, the heater, or both. The temperature control solenoids are under control of a temperature sensing unit. Those of skill in the art will recognize that alternative embodiments can locate the temperature sensing unit either before or after the temperature control chamber 36. In fact, more than one temperature sensing unit may be used to control the temperature controlled solenoids. Also, the temperature controlled solenoids may be placed before or after the chiller and the heater.

The heating and cooling of polish slurry 28 to control and maintain the slurry temperature constant, directly addresses the microscale changes in wafer temperature. For example, the rapid removal of a polish reaction formed film is of importance to maintaining a constant silicon polish rate and surface quality. In addition to temperature control, the control of silica to alkali ratio in order to prevent coagulation, settling-out, gelling and precipitation of slurry components.

The redox potential and the buffer capacity of the slurry 28 may also be controlled. The calculations of the redox potential capacity show that the redox potential of a typical silicic acid slurry is at its maximum when the slurry is fresh, that is, before its first use. A typical redox potential value is -75.3 millivolts, which corresponds to the redox potential of the slurry using a platinum redox electrode with a Silver/Silver Chloride reference electrode at room temperature. At the same time, the pH of the slurry was found to be 10.7, which corresponds to the pKa of the first and the second dissociation constants of the silicic acid. Using a typical batch of slurry the redox potential drops after the first run to -56.0 millivolts. After the second run, the redox potential value of slurry 28 drops to -48.1, -40.2, -34.1, -12.3 and +52.0 millivolts per run, respectively.

Compared to an ideal value of in the negative range, the redox potential following the sixth run has changed completely, while the pH has dropped from an initial pH of 10.7 to a pH of 9.5 at the end of the sixth run. The progressive, and then rapid change in the redox potential of the slurry 28 corresponds to a reduction in the buffering index of the slurry, and is a result of the self-dissociation of the water, the dissociation of silicic acid, the electrical neutrality of the slurry and the conservation of the added silicon introduced into the slurry 28 as a result of polishing the silicon wafers 24.

The polishing slurry 28 may be agitated in the redox potential control chamber 35 to minimize or eliminate the precipitation of SiOx aggregates in polishing slurry 28. Alternately, progressive neutralization of slurry 28 may be counteracted by combining an alkaline agent into the slurry 28. Combining a redox agent with slurry 28, reduces the rate of decay of the redox potential of slurry 28, thereby maintaining the redox potential of the slurry 28, and preventing the problems caused by a change in the redox potential of the slurry 28.

In one embodiment, the agents that may be combined to regulate the redox potential may be either oxidants or reducing agents. For use with the method of the present invention several oxidizing, and several reducing agents may be used. A redox potential control chamber 35 may be located within the slurry recirculation pathway. Examples of oxidants that may be used to lower the redox charge, include Cl₂, O₂, Br₂, and NaOCl. To reduce the polishing slurry, reducing agents such as SO₂, Na₂SO₃, or NaHSO₃ may be used. The use of the Nernst equation to calculate the relative contribution of agents is known to those of skill in the art.

The necessity for and the amount of an oxidizing, or a reducing agent, that is needed to maintain the redox potential into the slurry 28 in a redox control chamber 35 may be determined from slurry samples taken at strategic locations throughout the circulation path of the slurry 28. For example, redox potential may be tested proximate to the center drive 26, in the defoaming chamber 32, in the temperature control chamber 36, or in a pH control chamber 34. The oxidizing or reducing agents may be introduced in the redox potential control chamber 35 from an agent reservoir (not pictured). After the slurry 28 passes through the redox potential control chamber 35, a pump 38 circulates the slurry 28 back to the surface of the polishing pad 14.

While certain embodiments have been described this description is not intended to be construed in a limiting sense. Various modifications and combinations of the illustrative embodiments as well as other embodiments will be apparent to those of skill in the are upon reference to the description.

## Claims

1. A method for managing particulates in a chemical-mechanical polishing slurry, the method comprising:
circulating the polishing slurry in a chemical-mechanical wafer polishing apparatus;
passing the polishing slurry through a filtration
system; and filtering the particulate out of the polishing slurry.

2. The method as claimed in Claim 1, wherein the step of passing the polishing slurry through a filtration system comprises passing the polishing slurry through a filter constructed from a material selected from a group of materials comprising polypropylene, polyethylene, polyvinyl chloride, polyvinylidene chloride, polyvinylidene fluoride, polyester and glass fabric.

3. The method as claimed in Claim 1 or Claim 2, wherein the step of passing the polishing slurry through a filtration system comprises passing the polishing slurry through a hydrophilic filter.

4. The method as claimed in Claim 2 or Claim 3, wherein the step of passing the polishing slurry through a filtration system comprises passing the polishing slurry through a filter having an internal surface area of approximately 72 square inches.

5. The method as claimed in any of Claims 2 to 4 further comprising:
wetting the filter before passing the polishing slurry therethrough.

6. The method as claimed in any of Claims 2 to 5, wherein the step of passing the polishing slurry through a filtration system comprises passing the polishing slurry through a filter having a pore size between about 25 and 100 microns.

7. The method as claimed in Claim 6, wherein the step of passing the polishing slurry through a filtration system comprises passing the polishing slurry through a filter having a pore size of approximately 50 microns.

8. The method as claimed in any of Claims 1 to 7, wherein the step of filtering the particulate out of the polishing slurry further comprises filtering aggregates out of the polishing slurry.

9. The method as claimed in any of Claims 1 to 8, wherein the step of filtering the particulate out of the polishing slurry further comprises filtering precipitates out of the polishing slurry.

10. The method as claimed in any of Claims 1 to 9, wherein the step of filtering the particulate out of the polishing slurry further comprises filtering particles of SiOₓ out of the polishing slurry.

11. A method for managing particulate in a chemical-mechanical polishing slurry, the method comprising:
circulating the polishing slurry in a chemical-mechanical wafer polishing apparatus;
monitoring the pH of the polishing slurry;
combining an agent into the polishing slurry to adjust the pH of the polishing slurry;
passing the polishing slurry through a filtration system; and
filtering the particulate out of the polishing slurry.

12. The method as claimed in Claim 11, wherein the step of passing the polishing slurry through a filtration system further comprises passing the polishing slurry through a filter having a pore size between about 25 and 100 microns.

13. The method as claimed in Claim 11 or Claim 12, wherein the step of passing the polishing slurry through a filtration system further comprises passing the polishing slurry through a filter having a pore size of approximately 50 microns.

14. The method as claimed in any of Claims 11 to 13, wherein the step of combining an agent into the polishing slurry to adjust the pH of the polishing slurry comprises combining an alkali into the polishing slurry.

15. The method as claimed in any of Claims 11 to 14 further comprising the step of:
maintaining the pH of the polishing slurry between about 9.7 and 11.7.

16. The method as claimed in any of Claims 11 to 15, further comprising the step of:
agitating the polishing slurry.

17. The method as claimed in Claim 16, wherein the step of agitating the polishing slurry is arranged for minimizing the precipitation of SiOₓ aggregates in the polishing slurry.

18. The method as claimed in any of Claims 11 to 17, further comprising:
monitoring the temperature of the polishing slurry.

19. The method as claimed in Claim 18, further comprising:
exposing the polishing slurry to a temperature control element to adjust the temperature of the polishing slurry.
